# EUROPEAN PATENT APPLICATION

(11) **EP 4 596 133 A1**
(43) Date of publication of application: **06.08.2025**
(21) Application number: 25154322.9
(22) Date of filing: 28.01.2025
(51) Int. Cl.: B21D 22/02, B21D 53/92

(54) **METHOD OF MITIGATING WRINKLES DURING THE MANUFACTURE OF SUPER-PLASTICALLY FORMED PARTS**

(30) Priority: 01.02.2024 US 202418430471
(71) Applicant: The Boeing Company, Arlington, VA 22202 (US)
(72) Inventor: HENSON, Landon, Arlington, 22202 (US); SPURGERS, Jacob, Arlington, 22202 (US); JENNY, Craig, Arlington, 22202 (US)
(74) Representative: Boult Wade Tennant LLP

(57) **Abstract**

A method (200) of mitigating wrinkles during a manufacture of a super-plastically formed part, the method (200) comprising:
arranging (202) a plurality of flat sheets (104) into a part assembly (106), the plurality of flat sheets (104) comprising a first outer sheet (108) and a second outer sheet (110);
applying (204) a friction-modifying layer (120) to the first outer sheet (108) of the part assembly (106), wherein:
the first outer sheet (108) comprises a first portion (116) having a first percentage of coverage and a second portion (118) having a second percentage of coverage;
the friction-modifying layer (120) is applied at a first thickness (122) in the first portion (116) and a second thickness (124) in the second portion (118); and
the first thickness (122) and the second thickness (124) are different thicknesses;
placing (206) the part assembly (106) on a lower die (134) of a die system (130) such that the first outer sheet (108) is facing the lower die (134); and
moving an upper die (132) of the die system (130) in a forming direction (136) toward the lower die (134) to stretch and compress the part assembly (106) between the upper die (132) and the lower die (134) and to super-plastically form the part assembly (106) into a formed part (102).

## Description

### FIELD

This disclosure relates generally to manufacturing parts, and more particularly to mitigating wrinkles during the manufacturing of super-plastically formed parts.

### BACKGROUND

Super-plastic formation processes are commonly employed for producing parts with complex shapes and/or curvatures. Achieving a wrinkle-free final part or wrinkle-mitigated final part, wherein the final part, despite the presence of some wrinkles, can successfully pass inspection and meet quality standards, is a challenge when super-plastically forming parts. Wrinkles often emerge during the super-plastic formation process, rendering the resulting part unsuitable for use. Conventional approaches to mitigate or eliminate wrinkles in this process typically involve incorporating hard features into the die used for forming the part. However, incorporating the hard features presents substantial difficulties, as it is extremely difficult, if not impossible, to incorporate the specific number of features within the die geometry to achieve the necessary wrinkle mitigation. Moreover, modifying dies is an expensive process, often requiring multiple adjustments before determining the optimal combination for producing acceptable final parts.

### SUMMARY

The subject matter of the present application has been developed in response to the present state of the art, and in particular, in response to the problems of and needs created by, or not yet fully solved by, typical manufacturing of super-plastically formed parts. Generally, the subject matter of the present application has been developed to provide a method of mitigating wrinkles during the manufacture of super-plastically formed parts that overcome at least some of the above-discussed shortcomings of prior art techniques. Parts that can be processed using the method herein include aerospace parts.

In an example, there is a method of mitigating wrinkles during the manufacture of a super-plastically formed part. The method includes arranging a plurality of flat sheets into a part assembly. The plurality of flat sheets including a first outer sheet and a second outer sheet. The method also includes applying a friction-modifying layer to the first outer sheet of the part assembly. The first outer sheet includes a first portion having a first percentage of coverage and a second portion having a second percentage of coverage. The friction-modifying layer is applied at a first thickness in the first portion and a second thickness in the second portion. The first thickness and the second thickness are different thicknesses. The method further includes placing the part assembly on a lower die of a die system such that the first outer sheet is facing the lower die. Additionally, the method includes moving an upper die of the die system in a forming direction toward the lower die to stretch and compress the part assembly between the upper die and the lower die and to super-plastically form the part assembly into the formed part. The preceding subject matter of this paragraph characterizes example 1 of the present disclosure.

The method may include simulating a super-plastic formation of a simulated part assembly into a simulated formed part to predict at least one wrinkle-prone location within the simulated formed part. The preceding subject matter of this paragraph characterizes example 2 of the present disclosure, wherein example 2 also includes the subject matter according to example 1, above.

The first portion of the first outer sheet may correspond with the at least one wrinkle-prone location within the simulated formed part. The second portion of the first outer sheet may correspond with locations other than the at least one wrinkle-prone location within the simulated formed part. The step of applying the friction-modifying layer to the first outer sheet may include applying the friction-modifying layer to the first portion at the first thickness to mitigate wrinkles at the at least one wrinkle-prone location while super-plastically forming the part assembly into the formed part. The preceding subject matter of this paragraph characterizes example 3 of the present disclosure, wherein example 3 also includes the subject matter according to example 2, above.

The step of applying the friction-modifying layer to the first outer sheet may include applying the friction-modifying layer to the first outer sheet using a mask includes at least one aperture corresponding with the first portion. The preceding subject matter of this paragraph characterizes example 4 of the present disclosure, wherein example 4 also includes the subject matter according to any of examples 1-3, above.

The location of the at least one aperture of the mask, the shape of the at least one aperture, and the size of the at least one aperture may be predetermined based on a simulation of a super-plastic formation of a simulated formed part. The preceding subject matter of this paragraph characterizes example 5 of the present disclosure, wherein example 5 also includes the subject matter according to example 4, above.

The method may include forming a corner cutout at each corner of the part assembly to define a plurality of flanges. Each one of the plurality of flanges may extend between adjacent ones of the corner cutouts. The step of moving the upper die of the die system in the forming direction may include trapping each one of the plurality of flanges between die-blocks, coupled to the upper die, and the lower die, as the upper die of the die system is moved in the forming direction toward the lower die. The preceding subject matter of this paragraph characterizes example 6 of the present disclosure, wherein example 6 also includes the subject matter according to any of examples 1-5, above.

Prior to applying a friction-modifying layer, the method may include increasing a surface irregularity in an irregular portion of the first outer sheet of the part assembly. The preceding subject matter of this paragraph characterizes example 7 of the present disclosure, wherein example 7 also includes the subject matter according to any of examples 1-6, above.

The friction-modifying layer may be configured to precisely control the state of stress within the part assembly when super-plastically forming the part assembly into the formed part. The preceding subject matter of this paragraph characterizes example 8 of the present disclosure, wherein example 8 also includes the subject matter according to any of examples 1-7, above.

The first outer sheet may include a third portion having a third percentage of coverage. The friction-modifying layer may be applied at a third thickness in the third portion. The third thickness may be different than the first thickness and the second thickness. The preceding subject matter of this paragraph characterizes example 9 of the present disclosure, wherein example 9 also includes the subject matter according to any of examples 1-8, above.

The first thickness may be less than the second thickness. The preceding subject matter of this paragraph characterizes example 10 of the present disclosure, wherein example 10 also includes the subject matter according to any of examples 1-9, above.

The plurality of flat sheets may include at least one inner sheet disposed between the first outer sheet and the second outer sheet. The preceding subject matter of this paragraph characterizes example 11 of the present disclosure, wherein example 11 also includes the subject matter according to any of examples 1-10, above.

In another example, there is a method of mitigating wrinkles during the manufacture of a super-plastically formed part. The method includes subjecting a part assembly to a super-plastic forming process. The method also includes controlling a state of stress within the part assembly during the super-plastic forming process by non-uniformly applying a friction-modifying layer to an outer sheet of the part assembly prior to the super-plastic forming process, such that a thickness of the friction-modifying layer at least one wrinkle-prone location of the outer sheet is different than a thickness of the friction-modifying layer at other locations of the outer sheet. The preceding subject matter of this paragraph characterizes example 12 of the present disclosure.

The thickness of the friction-modifying layer at the at least one wrinkle-prone location may be less than the thickness of the friction-modifying layer at other locations of the outer sheet. The preceding subject matter of this paragraph characterizes example 13 of the present disclosure, wherein example 13 also includes the subject matter according to example 12, above.

The method may include simulating a super-plastic formation of a simulated part assembly into a simulated formed part to predict the at least one wrinkle-prone location within the simulated formed part. The preceding subject matter of this paragraph characterizes example 14 of the present disclosure, wherein example 14 also includes the subject matter according to any of examples 12-13, above.

In a further example, there is a formed part produced by a process. The process includes arranging a plurality of flat sheets into a part assembly. The plurality of flat sheets includes a first outer sheet and a second outer sheet. The process also includes applying a friction-modifying layer to the first outer sheet of the part assembly. The first outer sheet includes a first portion having a first percentage of coverage and a second portion having a second percentage of coverage. The friction-modifying layer is applied at a first thickness in the first portion and a second thickness in the second portion. The first thickness and the second thickness are different thicknesses. The process further includes placing the part assembly on a lower die of a die system such that the first outer sheet is facing the lower die. Additionally, the process includes moving an upper die of the die system in a forming direction toward the lower die to stretch and compress the part assembly between the upper die and the lower die and to super-plastically form the part assembly into the formed part. The preceding subject matter of this paragraph characterizes example 15 of the present disclosure.

The part assembly may include at least one inner sheet disposed between the first outer sheet and the second outer sheet. The preceding subject matter of this paragraph characterizes example 16 of the present disclosure, wherein example 16 also includes the subject matter according to example 15, above.

The at least one inner sheet may be formed into a network of cells between the first outer sheet and the second outer sheet when the part assembly is super-plastically formed into the formed part. The preceding subject matter of this paragraph characterizes example 17 of the present disclosure, wherein example 17 also includes the subject matter according to example 16, above.

At least one of the plurality of flat sheets may include at least one of a size, a shape, or a thickness that is different from the size, the shape, or the thickness of others of the plurality of flat sheets. The preceding subject matter of this paragraph characterizes example 18 of the present disclosure, wherein example 18 also includes the subject matter according to any of examples 15-17, above.

The process may include forming a corner cutout at each corner of the part assembly to define a plurality of flanges. Each one of the plurality of flanges may extend between adjacent ones of the corner cutouts. The step of moving the upper die of the die system in the forming direction may include trapping each one of the plurality of flanges between die-blocks, coupled to the upper die, and the lower die, as the upper die of the die system is moved in the forming direction toward the lower die. The preceding subject matter of this paragraph characterizes example 19 of the present disclosure, wherein example 19 also includes the subject matter according to any of examples 15-18, above.

Each one of the plurality of flat sheets may include a titanium material. The preceding subject matter of this paragraph characterizes example 20 of the present disclosure, wherein example 20 also includes the subject matter according to any of examples 15-19, above.

The described features, structures, advantages, and/or characteristics of the subject matter of the present disclosure may be combined in any suitable manner in one or more examples. In the following description, numerous specific details are provided to impart a thorough understanding of examples of the subject matter of the present disclosure. One skilled in the relevant art will recognize that the subject matter of the present disclosure may be practiced without one or more of the specific features, details, components, materials, and/or methods of a particular example. In other instances, additional features and advantages may be recognized in certain examples that may not be present in all examples. Further, in some instances, well-known structures, materials, or operations are not shown or described in detail to avoid obscuring features of the subject matter of the present disclosure. The features and advantages of the subject matter of the present disclosure will become more fully apparent from the following description and appended claims, or may be learned by the practice of the subject matter as set forth hereinafter.

### BRIEF DESCRIPTION OF THE DRAWINGS

In order that the advantages of the subject matter may be more readily understood, a more particular description of the subject matter briefly described above will be rendered by reference to specific examples that are illustrated in the appended drawings. Understanding that these drawings depict only typical examples of the subject matter, they are not therefore to be considered to be limiting of its scope. The subject matter will be described and explained with additional specificity and detail through the use of the drawings, in which:
Figure 1 is an exemplary schematic diagram illustrating a process for manufacturing a super plastically formed part;
Figure 2A is a schematic, side view of one example of a part assembly, prior to a super-plastic formation process;
Figure 2B is a schematic, side view of another example of a part assembly, prior to a super plastic formation process;
Figure 3 is an exemplary schematic, perspective, exploded view of a die system and part assembly;
Figure 4A is an exemplary schematic, top view of a part assembly, prior to a super-plastic formation process;
Figure 4B is an exemplary schematic, perspective view of a formed part, formed from the part assembly of Figure 4A, during the super-plastic formation process;
Figure 5 is an exemplary schematic, perspective view of the die system of Figure 3, during a super-plastic formation process;
Figure 6A is a schematic, top view of one example of a friction-modifying layer on a simulated part assembly undergoing a simulation to a simulated formed part;
Figure 6B is a schematic, top view of one example of a friction-modifying layer on a part assembly undergoing a super-plastic formation process to a formed part
Figure 7 is an exemplary schematic flow diagram of a method of mitigating wrinkles during the manufacture of a super-plastically formed part; and
Figure 8 is an exemplary schematic flow diagram of another method of mitigating wrinkles during the manufacture of a super-plastically formed part

### DETAILED DESCRIPTION

Reference throughout this specification to "one example," "an example," or similar language means that a particular feature, structure, or characteristic described in connection with the example is included in at least one example of the subject matter of the present disclosure. Appearances of the phrases "in one example," "in an example," and similar language throughout this specification may, but do not necessarily, all refer to the same example. Similarly, the use of the term "implementation" means an implementation having a particular feature, structure, or characteristic described in connection with one or more examples of the subject matter of the present disclosure, however, absent an express correlation to indicate otherwise, an implementation may be associated with one or more examples. Furthermore, the described features, advantages, and characteristics of the examples may be combined in any suitable manner. One skilled in the relevant art will recognize that the examples may be practiced without one or more of the specific features or advantages of a particular example. In other instances, additional features and advantages may be recognized in certain examples that may not be present in all examples.

Disclosed herein are examples of methods for manufacturing wrinkle-mitigated formed parts and formed parts produced by the method. Wrinkles often occur in super-plastically formed parts when the formed part is under non-uniform stress states during manufacturing. Wrinkles often occur in a super-plastically formed part as super-plastically formed parts are often designed with complex shapes and curvatures. Traditional approaches to minimizing wrinkle occurrence during the super-plastic formation process of formed parts are often insufficient, particularly when dealing with complex part designs. The method herein leverages the use of selective friction coefficients, providing a means to manage stress within the part during super-plastic formation and effectively reduce wrinkles. In other words, the method ensures a more consistent and uniform stress state throughout the manufacturing process. The friction coefficients can be modified using various methods including but not limited to applying a friction-modifying layer, increasing surface irregularity, and stretching portion of the part (e.g., flanges). In some examples, prior to the super-plastic formation process, a friction-modifying layer is applied to a part assembly (i.e., formed part precursor) in various thicknesses. The application of the various thicknesses of friction-modifying layer serves to adjust the friction coefficient at locations corresponding to wrinkles-prone locations on the part assembly. Accordingly, applying a friction-modifying layer with a non-uniform thickness to the part assembly aims to establish a more consistent stress state across the part assembly, ensuring a uniform stretch and/or stress condition, to minimize the occurrence of wrinkles in the part assembly. Subsequently, the part assembly, with the friction-modifying layer applied, is placed on a lower die of a die system. As an upper die of the die system is moved in a forming direction, the part assembly undergoes stretching and compression between the upper and lower dies, resulting in the super-plastic formation of the part assembly into the formed part. The application of the friction-modifying layer facilitates the manufacturing of formed parts under a controlled stress state, thereby achieving wrinkle-mitigated, and in some cases, wrinkle-free formed parts. As used herein, a controlled stress state refers to a deliberate and regulated management of stress on a material during a manufacturing process. In certain instances, this control aims to achieve a uniform stress state across the part assembly during the super-plastic formation process.

The formed parts produced by the super-plastic formation process may be used for any of various applications. In some examples, the formed parts may be used in the aerospace industry. For example, super-plastically formed parts may be used for forming critical elements of an aircraft, such as the inner wall of aircraft engines. Super-plastically formed part prove advantageous in such applications, attributed to the optimal combination of lightweight attributes and durability inherent in materials such as titanium. Additionally, super-plastically formed part may be used in other applications, such as automotive sector, medical devices, consumer electronics, defense industry, etc.

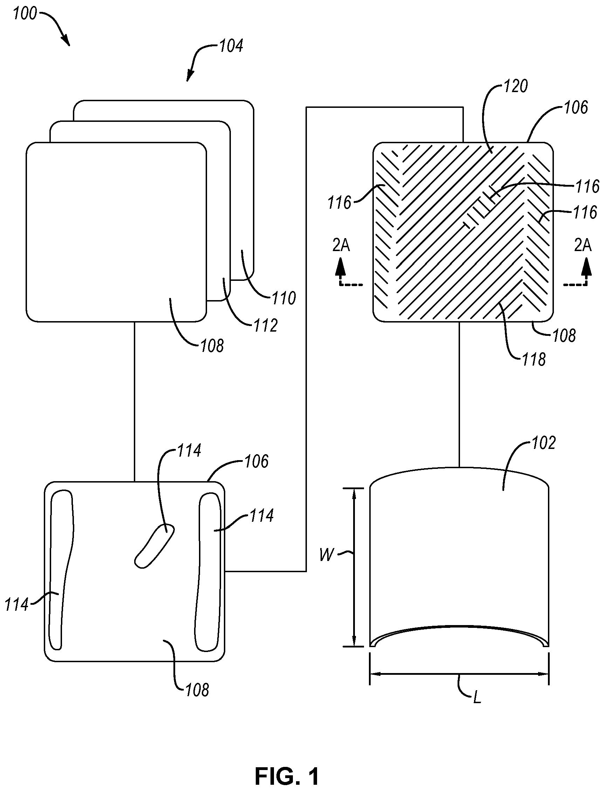

Referring to Figure 1, according to some examples, disclosed herein is a process 100 for manufacturing a formed part 102. In some cases, the process 100 is a super-plastic formation process, however, other processes for forming parts using dies may also be used including but not limited to die casting, hydroforming, incremental sheet forming, compression molding, etc. The process 100 includes arranging a plurality of flat sheets 104 into a part assembly 106 (i.e., grouping of flat sheets). The plurality of flat sheets 104 includes a first outer sheet 108 and a second outer sheet 110. In some examples, the plurality of flat sheets 104 may include at least one inner sheet 112 disposed between the first outer sheet 108 and the second outer sheet 110. Although shown in Figure 1 with one inner sheet 112, any number of inner sheets 112 may be used between the first outer sheet 108 and the second outer sheet 110. For example, two inner sheets 112 may be disposed between the first outer sheet 108 and the second outer sheet 110. In some cases, the total thickness of the plurality of flat sheets 104, may impose constraints (i.e., limitations) on the number of inner sheets 112, due to forming concerns.

In some examples, each one of the plurality of flat sheets 104 are identical, or substantially identical, flat sheets having the same size, shape, and thickness. That is, each one of the plurality of flat sheets 104 may be configured with a common width, common length, and common thickness. In some other examples, at least one of the plurality of flat sheets 104 has a size, shape, or thickness, that is different from the size, shape, or thickness, of others of the plurality of flat sheets 104. For example, the inner sheet 112 may have size that is different from the first outer sheet 108 and the second outer sheet 110. Specifically, the inner sheet 112 may have a smaller perimeter, which ensures the inner sheet 112 does not extend to each edge of the first outer sheet 108 and the second outer sheet 110. In some other examples, the inner sheet 112 may have a different thickness, or shape, than the first outer sheet 108 and the second outer sheet 110. Additionally, in some examples, the first outer sheet 108 may have a different size, shape, or thickness from the second outer sheet 110. Differences between the first outer sheet 108 and the second outer sheet 110 may be preferred when specific variations in the final outer surfaces of the formed part 102 are desired or necessary.

In some examples, each one of the plurality of flat sheets 104 comprises and/or consists of a same material or configuration of materials. Specifically, each one of the plurality of flat sheets 104 comprises a material or configuration of materials that exhibits super plastic behavior. That is, the ability of the material or configuration of materials to undergo super-plastic deformation (i.e., deformation without fracture). For example, each one of the plurality of flat sheets 104 may comprise a metal material or a metal alloy. The material may be configured with uniformity across one or more of a length, width, and thickness. In some examples, the plurality of flat sheets 104 may at least partially made of a titanium material.

Some, or an entirety, of the plurality of flat sheets 104 of the part assembly 106 may be temporarily or permanently joined through methods such as clamping, welding, fastening, adhesives, and similar bonding techniques. Additionally, in some examples, the inner sheet 112 may feature a cell pattern applied through methods such as printing or resistance welding. For example, the cell pattern may be resistance welded as a series of thousands of resistance welds within the inner sheet 112. During the process 100, the cell pattern is configured to be transformed into a network of cells between the first outer sheet 108 and the second outer sheet 110. This is achieved by stretching the cell pattern, resulting in the formation of an internal cellular structure (i.e., network of cells), during the process 100.

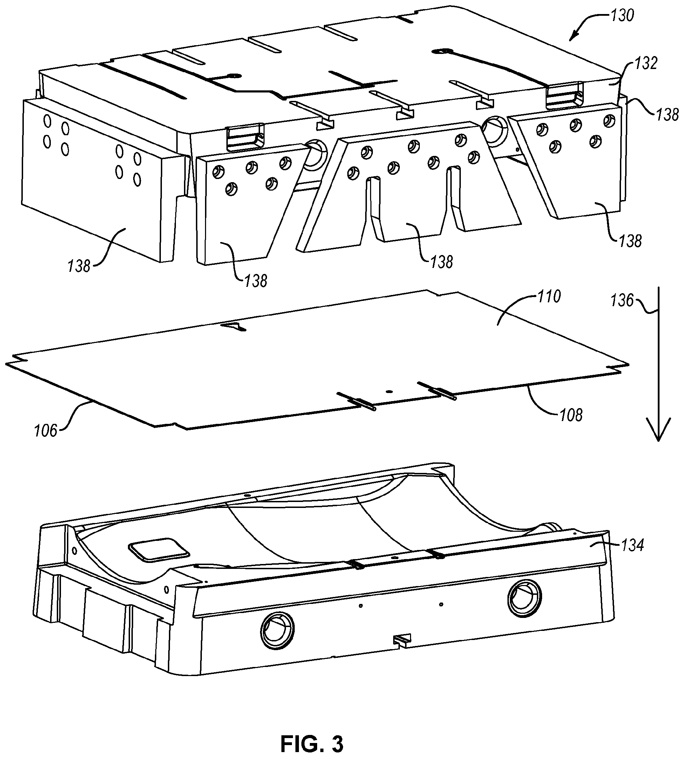

The process 100 may also include determining a wrinkle-prone location 114 of the part assembly 106. The part assembly 106 may have multiple wrinkle-prone locations 114, such as the three wrinkle prone locations identified in Figure 1. Although shown with three wrinkle-prone locations 114, the part assembly 106 may have any number of wrinkle-prone locations 114, including more or less than three wrinkle-prone locations 114. Additionally, the wrinkle-prone locations 114 can be any size or shape, depending on the size or shape of the wrinkles, and can include an area corresponding with one or more wrinkles. As shown, the wrinkle-prone locations 114 are determined on the first outer sheet 108. The first outer sheet 108 is the outermost layer of the part assembly 106, which is configured to be deformed in a specified forming direction (see, i.e., Figure 3). In some other examples, the wrinkle-prone locations 114 may also be determined on the second outer sheet 110. As used herein, the wrinkle-prone locations 114 refer to an area of the part assembly 106 that is expected to undergo wrinkling. Wrinkling in wrinkle-prone locations 114 can result from various factors, including significant stretching, complex curvature, intricate shapes, final shape considerations, and the like. Predictive measures for determining wrinkle-prone locations 114 can be established through super-plastic formation simulations, experimental testing, historical data and experience, and/or analytical methods.

The process 100 also includes applying a friction-modifying layer 120 to the first outer sheet 108. In some examples, the friction-modifying layer 120 is applied to an entirety of the first outer sheet 108, effectively coating the first outer sheet 108 with the friction-modifying layer 120. In some other examples, the friction-modifying layer 120 may be selectively applied to specific portions of the first outer sheet 108, rather than covering the entirety of the first outer sheet 108. In other words, the first outer sheet 108 may have at least one portion having no friction-modifying layer 120, that is, an area or multiple areas of zero thickness of friction-modifying layer 120. The friction-modifying layer 120 is applied in different thicknesses to different portions of the first outer sheet 108 to adjust the friction coefficient corresponding to specific locations prone to wrinkles on the first outer sheet 108 of the part assembly 106. In other words, the friction-modifying layer 120 is non-uniformly applied to the first outer sheet 108. In some examples, the first outer sheet 108 includes a first portion 116 and a second portion 118. The first portion 116 is applied at a first percentage of coverage of the first outer sheet 108 and the second portion 118 is applied at a second percentage of coverage of the first outer sheet 108. As used herein, the percentage of coverage refers to the proportion of the first outer sheet that is coated with the friction-modifying layer in a corresponding portion. In some examples, the first percentage of coverage and the second percentage of coverage encompass the entire first outer sheet 108, totaling one hundred percent coverage. In some other examples, the first percentage of coverage and the second percentage of coverage may be less than one hundred percent coverage of the first outer sheet 108, allowing for areas on the first outer sheet 108 without the friction-modifying layer 102 or areas with other thicknesses of the friction-modifying layer 102.

Additionally, the friction-modifying layer 120 is configured to be applied to the first portion 116 at a first thickness and applied to the second portion 118 at a second thickness. The first thickness and the second thickness are different thicknesses. The first portion 116 corresponds with at least one wrinkle-prone location 114. In some cases, the first portion 116 may directly correspond with a wrinkle-prone location 114, such that the first portion 116 encompasses the wrinkle-prone location 114. However, in some other cases, the first portion 116 may indirectly correspond with at least one wrinkle-prone location 114, such that the first portion 116 does not encompass the wrinkle-prone location 114 directly (i.e., separate location), which is the case because modifying the friction coefficient in a location distinct from the wrinkle-prone location 114 can affect wrinkle formation in at least one wrinkle-prone location 114.

The friction-modifying layer 120 is configured to precisely control a state of stress within the part assembly 106. That is, the state of stress is intentionally and accurately managed within the part assembly 106 during the super-plastic forming process. Accordingly, the friction-modifying layer 120 allows for the adjustment and regulation of stress levels throughout the part assembly 106. This precise control aims to optimize the super-plastic forming process, ensuring that the distribution and magnitude of stresses within the material are managed effectively.

In some examples, the process 100 also includes applying the friction-modifying layer 120 to the second outer sheet 110. Similar to the first outer sheet 108, the friction-modifying layer 120 may be selectively applied or applied to an entirety of the second outer sheet 110. Additionally, the friction-modifying layer 120 may be applied in different thicknesses to different portions of the second outer sheet 110 to adjust the friction coefficient at specific locations prone to wrinkles on the second outer sheet 110 of the part assembly 106.

The friction-modifying layer 120 may be any coating material that can be applied to the part assembly 106. In some cases, the friction-modifying layer 120 may also serve as a mold release agent configured to facilitate the efficient separation of the formed part 102 from the upper die and lower die after the completion of the process 100. Examples of possible materials of the friction-modifying layer 120 include boron nitride or graphite. Other alternatives may involve the use of polytetrafluorethylene, molybdenum disulfide, silicone-based coatings, or specialized polymer blends tailored for friction modification and mold release properties. The friction-modifying layer 120 may be applied to the part assembly 106 through various methods, such as spraying, painting, or printing.

After applying the friction-modifying layer 120 to the part assembly 106, the process 100 includes forming the part assembly 106 into the formed part 102. For example, the process 100 may be a super-plastic formation process that super-plastically forms the part assembly 106 into the formed part 102. Initially, the part assembly 106 with the friction-modifying layer 120, has a planar, 2-dimensional, shape. However, the part assembly 106 may be super-plastically formed into a nonplanar shape, such as a shape having complex contours and/or cutouts. For example, as shown in Figure 1, the planar, 2-dimensional, part assembly 106 has been formed into the formed part 102 with a non-planar, 3-dimensional, shape. The formed part 102 may be defined with a length (L) and a width (W), although the length (L) and the width (W) may not necessarily be constant along an entirety of the formed part 102 as they are in Figure 1.

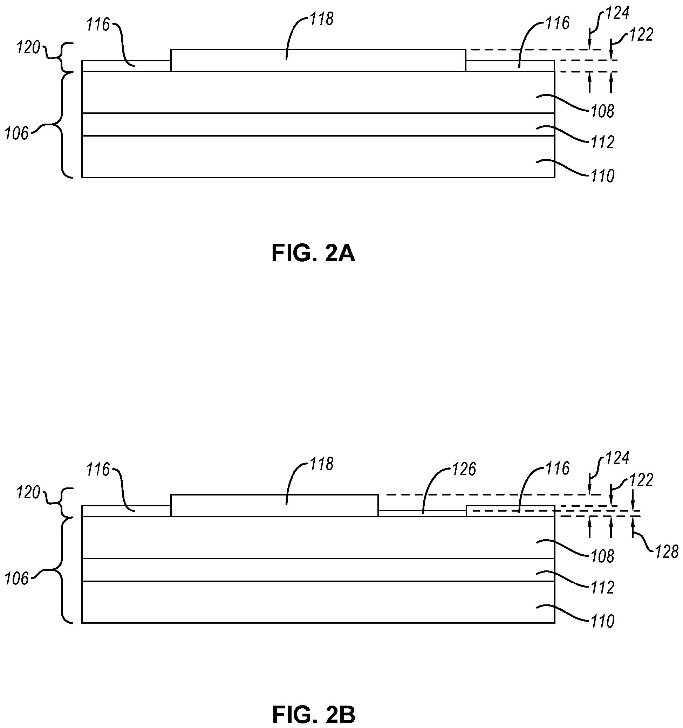

Referring to Figure 2A, a side view taken through line 2A of Figure 1, is shown. The part assembly 106 includes the friction-modifying layer 120 along the entirety of the first outer sheet 108. The friction-modifying layer 120 is applied in the first portion 116 at a first thickness 122 and having the first percentage of coverage. Additionally, the friction-modifying layer 120 is applied in the second portion 118 at a second thickness 124 and having the second percentage of coverage. The first thickness 122 is less than the thickness of the second thickness 124. That is, the friction-modifying layer 120 is varied along the length of the part assembly 106. Specifically, the thickness of the friction-modifying layer 120 in the first portion 116 is less than the thickness in the second portion 118. That is, the thinner layer of friction-modifying layer 120 in the first portion 116 results in a higher coefficient of friction compared to the thicker layer of friction-modifying layer 120 in the second portion 118, which has a lower coefficient of friction. This disparity allows for increased stretchability in the regions associated with the higher coefficient of friction, contributing to effective wrinkle mitigation or elimination in corresponding areas of the part assembly 106. As shown, the first portion 116 having the first percentage of coverage and the second portion 118 having the second percentage of coverage encompass the entirety of the first outer sheet 108.

The friction-modifying layer 120 may be applied to the part assembly 106 in more than two thickness variations. That is, in some examples, at least three thicknesses of the friction-modifying layer 120 may be applied to the part assembly 106. For example, as shown in Figure 2B, the part assembly 106 includes a third portion 126 of the friction-modifying layer 120 applied at a third thickness 128 and having a third percentage of coverage. The third thickness 128 is different from the first thickness 122 and the second thickness 124. In other words, the third thickness 128 may vary in thickness compared to both the first thickness 122 and the second thickness 124. In some examples, the third thickness 128 may be less than the first thickness 122 and the second thickness 124, such as shown in Figure 2B. That is, the third portion 126 has a higher coefficient of friction compared to the first portion 116 and the second portion 118. Accordingly, selective thickness variations of the friction-modifying layer 120 are used to mitigate wrinkle formation in wrinkle-prone locations 114, which some portions requiring differing coefficient of friction to effectively mitigate wrinkling. As shown, the first portion 116 having the first percentage of coverage, the second portion 118 having the second percentage of coverage encompass the entirety of the first outer sheet 108, and the third portion 128 having the third percentage of coverage encompass the entirety of the first outer sheet 108.

The friction-modifying layer 120 may be applied to the part assembly 106 using a mask having at least one aperture corresponding to a specific section of the part assembly 106, such as the first portion 116. In other words, the mask acts as a selective barrier, allowing the friction-modifying layer 120 to be applied selectively to the designated area, creating a controlled and defined layer within the aperture of the mask. Additional masks, with apertures corresponding to other sections of the part assembly 106, may be used to add the friction-modifying layer 120 to other sections of the part assembly 106. The location, shape, and size of the at apertures of the mask may be predetermined based on super-plastic formation simulations, experimental testing, historical data and experience, and/or analytical methods. Accordingly, one or more masks may be used to apply the friction-modifying layer 120 in the correct thickness to specific sections of the part assembly 106. In some examples, characteristics of the mask, such as the location, size, and shape of the apertures of the mask may be predetermined based on a modeling and simulation approach that simulates the super-plastic formation of the formed part 154. In some other examples, characteristics of the mask may be derived from the wrinkles observed in a trial part, that is, a real-world application of super-plastic formation. In yet other examples, characteristics of the mask may be established through a hybrid approach, combining insights from both the trial part and a simulation process.

A die system 130, such as the representative die system shown in an exploded view in Figure 3, is utilized to form the part assembly 106 into the formed part 102. The die system 130 includes an upper die 132 and a lower die 134. The upper die 132 is configured to be moved in a forming direction 136 toward the lower die 134 to stretch and compress the part assembly 106 between the upper die 132 and the lower die 134. That is, the die system 130 is used to perform the process 100, such as a super-plastically formation process, of forming the part assembly 106 into the formed part 102. The first outer sheet 108 of the part assembly 106 is configured to be placed on the lower die 134 of the die system 130, such that the first outer sheet 108 is facing the lower die 134, and the second outer sheet 110 is facing the upper die 132. Accordingly, the first outer sheet 108 is deformed along the forming direction 136 by the die system 130.

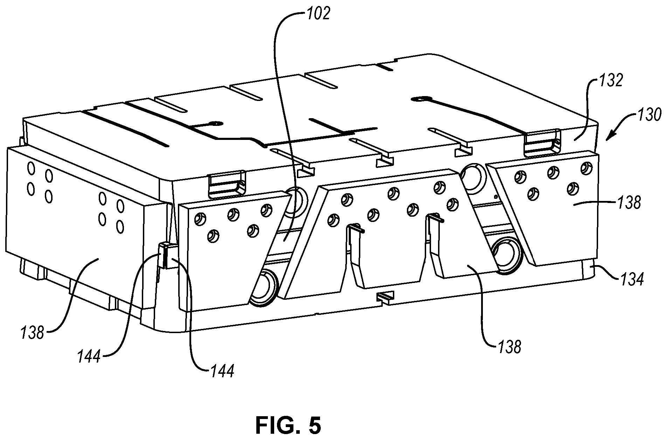

In some examples, the upper die 132 includes a plurality of die-blocks 138. The die-blocks 138 are coupled to an outer side surface of the upper die 132, extending beyond a forming plane of the upper die 132. The die-blocks 138 may be coupled to more than one outer side surface of the upper die 132, and in some examples, may be coupled to each outer side surface of the upper die 132. The die-blocks 138 may be coupled in any of various methods, including fasteners or welding. Additionally, the die-blocks 138 may be formed as a single unitary unit with the upper die 132. Die-blocks 138 may be separated by a separation distance from other adjacent die-blocks 138. The die-blocks 138 are configured to contact the second outer sheet 110 of the part assembly 106 before the upper die 132, as the upper die 132 moves in the forming direction 136 towards the lower die 134. As shown in Figure 5, the die-blocks 138 induce bending in an edge portion of the part assembly 106 between the die-blocks 138 and the lower die 134. Moreover, the die-blocks 138 are configured to immobilize the part assembly 106, preventing the bent section from retracting into the die system 130. That is, the forces exerted between the die-blocks 138 and the lower die 134 secure the edge portion of the part assembly 106 in place, while the remaining portion of the part assembly 106 undergoes stretching and compression within the die system 130.

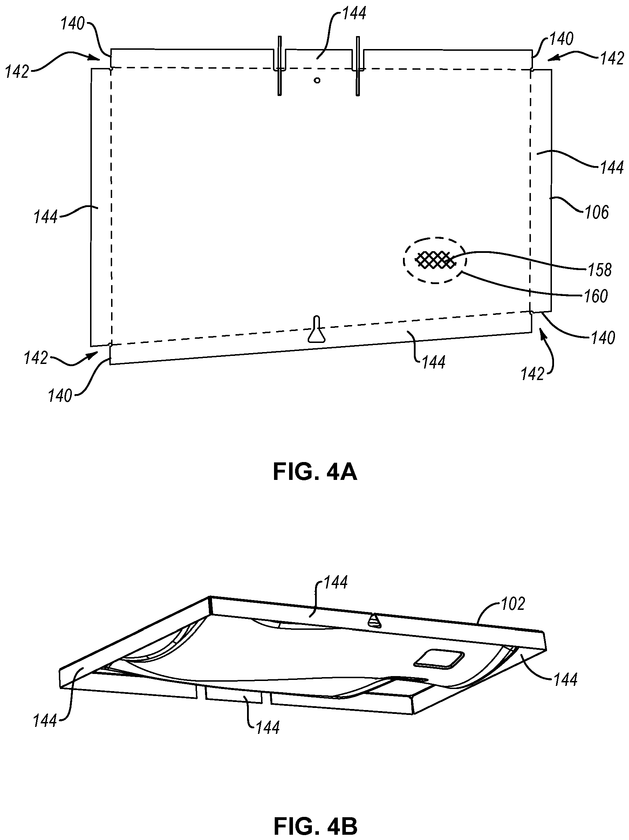

Referring to Figure 4A, in some examples, the part assembly 106 may include corner cutouts 140 at each corner 142 of the part assembly 106 to assist in the bending of the edge portion of the part assembly 106 by the die-blocks 138. That is, corner cutouts 140 are formed (e.g., removed) at each corner 142 in the part assembly 106, defining a plurality of flanges 144. Each one of the plurality of flanges 144 extends between adjacent ones of the corner cutouts 140 and are configured to undergo bending between the die-blocks 138 and the lower die 134. As the upper die 132 is moved in the forming direction towards the lower die 134, each one of the plurality of flanges 1414 is trapped (i.e., securely held in place) between the die-blocks 138 and the lower die 134. This trapping mechanism ensures precise control over the positioning of each one of the plurality of flanges 144 during the forming process. After the process 100, the plurality of flanges 144 of the formed part 102 extend downward, in some examples, parallel to the forming direction 136, as shown in Figure 4B. In some examples, the plurality of flanges 144 may be trimmed from the formed part 102 after the process 100. The plurality of flanges 144 may be used to modify the friction coefficient at specific locations of the part assembly 106. In other words, the pressure exerted on each one of the plurality of flanges 144 between the die-blocks 138 and the lower die 140 has the capability to adjust the friction coefficient adjacent to the corresponding flange.

The friction coefficient of specific locations on the part assembly 106 may also be modified by increasing a surface irregularity 158 (i.e., roughness) in an irregular portion 160 of the part assembly 106. That is, by intentional creating roughness in certain regions, the frictional characteristics of those areas can be modified or adjusted. Specifically, by increasing the surface irregularity 158 within the irregular portion 160, the friction coefficient is increased in the irregular portion 160, ensuring a more uniform stress state within the part assembly 106 to minimize the occurrence of wrinkles in the part assembly 106. Increasing the surface irregularity 158 in the irregular portion 160 of the part assembly 106 can be implemented independently, without adding the friction-modifying layer 120 to the irregular portion 160. Alternatively, increasing the surface irregularity 158 may be used in conjunction with the friction-modifying layer 120, where the friction-modifying layer 120 is applied to the irregular portion 160 after the surface irregularity 158 has been increased. The process of increasing the surface irregularity 158 can be achieved through any of various processes including mechanical abrasion (e.g., sanding), chemical etching, laser etching, shot peening, etc.

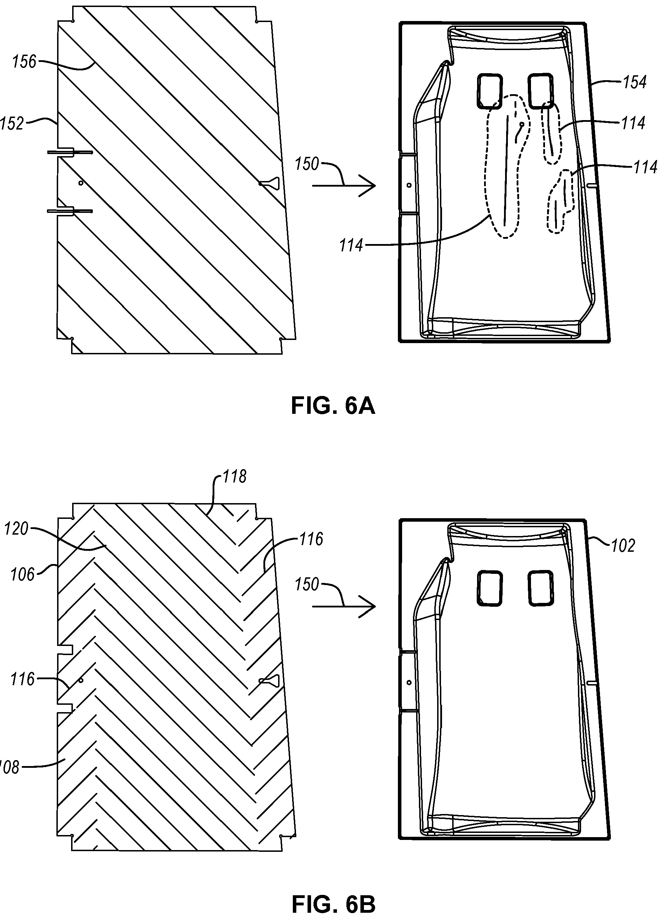

As shown in Figures 6A and 6B, a simulation of the process 100 can be performed to predict wrinkle-prone locations 114. Before initiating the simulation process, a model of the die system and part assembly (i.e., simulated part assembly 152), such as a CAD model, is modeled to accurately reflect the die geometry, part assembly configuration, and material properties. The modeling phase allows for the incorporation of realistic parameters into the simulation process enhancing the predictive capabilities of the simulation process, enabling the identification of potential wrinkle-prone locations and providing insights for optimizing the manufacturing process. During the simulation, a simulated part assembly 152 undergoes a simulation process 150 to generate a simulated formed part 154. During an initial simulation, the simulated part assembly 152 exhibits a uniform friction coefficient. That is, in some examples, the simulated part assembly 152 features a uniform thickness of simulated friction-modifying layer 156, representing a uniform friction coefficient across the simulated part assembly 152. In some other examples, the simulated part assembly 152 is modeled without a simulated friction-modifying layer 156. Accordingly, following the simulation process 150, the simulated formed part 154 exhibits wrinkling, as the uniform friction coefficients in the simulated part assembly 152 during formation results in wrinkling. Wrinkle-prone locations 114 can then be identified within the simulated formed part 154. Subsequent simulations can be performed to determine the optimal non-uniform thicknesses of the simulated friction-modifying layer 156 for application to the simulated part assembly 152 to represent a non-uniform friction coefficient across the simulated part assembly 152. The subsequent simulations aim to yield a simulated formed part 154 that is effectively mitigated against wrinkling, and in certain instances, achieves a wrinkle-free outcome. Moreover, the objective of the subsequent simulations is to generate a simulated formed part 154 that would pass inspection criteria and produce an acceptable final part. In some cases, complete elimination of all wrinkling from the simulated formed part 154 may not be achievable. The simulations can be performed using a variety of software applications and techniques. Additionally, the simulations can be used to determine the utility of increasing surface irregularity to the simulated part assembly 152, in conjunction with or separately from, the simulated friction-modifying layer 156.

By determining the optimal non-uniform thicknesses for the simulated friction-modifying layer 156 and/or surface irregularity using simulations, the process 100 of forming a wrinkle-mitigated formed part 102 can be optimized before forming a formed part, eliminating the need for time-consuming and expensive manufacturing trial and error for forming a formed part from a part assembly. As shown in Figure 6B, the first portion 116 and the second portion 118 of the part assembly 106 are determined, based on the results of the simulations, and the predetermined thicknesses of the friction-modifying layer 120 are applied, to form the formed part 102 with mitigated wrinkling. That is, the non-uniform thicknesses of friction-modifying layer 120 determined during the simulation process is applied to the part assembly 106 to enable a controlled stress state within the part assembly 106 during the process 100.

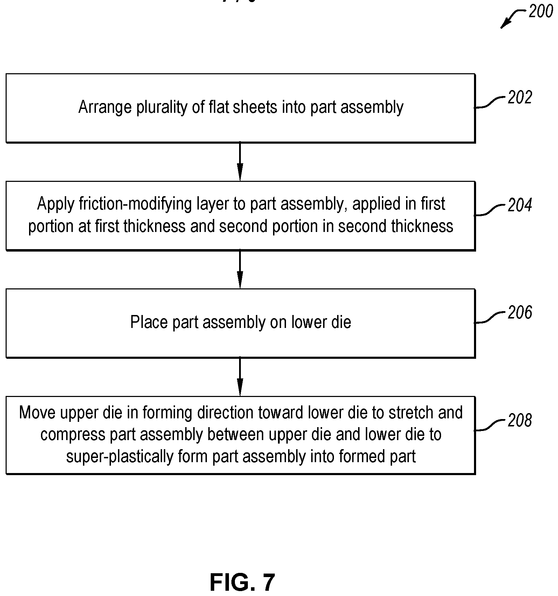

Referring to Figure 7, a method 200 of mitigating wrinkles during the manufacture of a super-plastically formed part is shown. The method 200 includes (block 202) arranging a plurality of flat sheets 104 into a part assembly 106. The plurality of flat sheets 104 includes a first outer sheet 108 and a second outer sheet 110. In some examples, at least one inner sheet 112 is disposed between the first outer sheet 108 and the second outer sheet 110. The method 200 also includes (block 204) applying a friction-modifying layer 120 to the first outer sheet 108 of the part assembly 106. The friction-modifying layer 120, in some cases, may also be applied to the second outer sheet 110. The first outer sheet 108 includes a first portion 116 and a second portion 118. The friction-modifying layer 120 is applied at a first thickness 122 in the first portion 116 and a second thickness in the second portion 118. The first thickness 122 and the second thickness 124 are different thicknesses. That is, the friction-modifying layer 120 is applied in non-uniform thicknesses on the part assembly 106.

The method 200 also includes (block 206) placing the part assembly 106 on a lower die 134 of a die system 130 such that the first outer sheet 108 is facing the lower die 134. The method 200 further includes (block 208) moving an upper die 132 of the die system 130 in a forming direction 136 toward the lower die 134 to stretch and compress the part assembly 106 between the upper die 132 and the lower die 134 and to super-plastically form the part assembly 106 into a formed part 102.

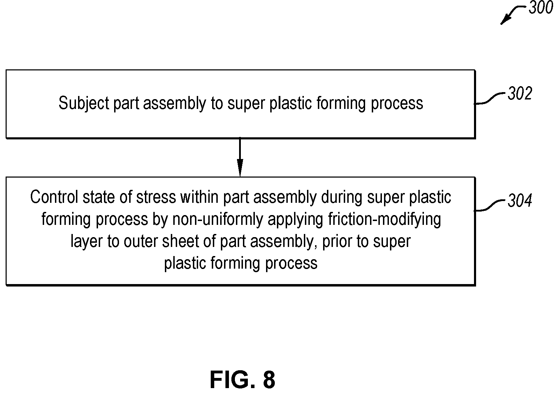

Referring to Figure 8, another method 300 of mitigating wrinkles during the manufacture of a super plastically formed part is shown. The method 300 includes (block 302) subjecting a part assembly 106 to a super-plastic forming process. The method 300 also includes (block 304) controlling a state of stress within the part assembly 106 during the super-plastic forming process by non-uniformly applying a friction-modifying layer 120 to an outer sheet of the part assembly 106 prior to the super-plastic forming process, such that a thickness of the friction-modifying layer 120 on at least one wrinkle-prone location 114 of the outer sheet is different than a thickness of the friction-modifying layer 120 at other locations of the outer sheet. The outer sheet may be the first outer sheet 108, the second outer sheet 110, or both the first and second outer sheet.

In the above description, certain terms may be used such as "up," "down," "upper," "lower," "horizontal," "vertical," "left," "right," "over," "under" and the like. These terms are used, where applicable, to provide some clarity of description when dealing with relative relationships. But, these terms are not intended to imply absolute relationships, positions, and/or orientations. For example, with respect to an object, an "upper" surface can become a "lower" surface simply by turning the object over. Nevertheless, it is still the same object. Further, the terms "including," "comprising," "having," and variations thereof mean "including but not limited to" unless expressly specified otherwise. An enumerated listing of items does not imply that any or all of the items are mutually exclusive and/or mutually inclusive, unless expressly specified otherwise. The terms "a," "an," and "the" also refer to "one or more" unless expressly specified otherwise. Further, the term "plurality" can be defined as "at least two."

Additionally, instances in this specification where one element is "coupled" to another element can include direct and indirect coupling. Direct coupling can be defined as one element coupled to and in some contact with another element. Indirect coupling can be defined as coupling between two elements not in direct contact with each other, but having one or more additional elements between the coupled elements. Further, as used herein, securing one element to another element can include direct securing and indirect securing. Additionally, as used herein, "adjacent" does not necessarily denote contact. For example, one element can be adjacent another element without being in contact with that element.

As used herein, the phrase "at least one of", when used with a list of items, means different combinations of one or more of the listed items may be used and only one of the items in the list may be needed. The item may be a particular object, thing, or category. In other words, "at least one of" means any combination of items or number of items may be used from the list, but not all of the items in the list may be required. For example, "at least one of item A, item B, and item C" may mean item A; item A and item B; item B; item A, item B, and item C; or item B and item C. In some cases, "at least one of item A, item B, and item C" may mean, for example, without limitation, two of item A, one of item B, and ten of item C; four of item B and seven of item C; or some other suitable combination.

Unless otherwise indicated, the terms "first," "second," etc. are used herein merely as labels, and are not intended to impose ordinal, positional, or hierarchical requirements on the items to which these terms refer. Moreover, reference to, e.g., a "second" item does not require or preclude the existence of, e.g., a "first" or lower-numbered item, and/or, e.g., a "third" or higher-numbered item.

As used herein, a system, apparatus, structure, article, element, component, or hardware "configured to" perform a specified function is indeed capable of performing the specified function without any alteration, rather than merely having potential to perform the specified function after further modification. In other words, the system, apparatus, structure, article, element, component, or hardware "configured to" perform a specified function is specifically selected, created, implemented, utilized, programmed, and/or designed for the purpose of performing the specified function. As used herein, "configured to" denotes existing characteristics of a system, apparatus, structure, article, element, component, or hardware which enable the system, apparatus, structure, article, element, component, or hardware to perform the specified function without further modification. For purposes of this disclosure, a system, apparatus, structure, article, element, component, or hardware described as being "configured to" perform a particular function may additionally or alternatively be described as being "adapted to" and/or as being "operative to" perform that function.

The schematic flow chart diagrams included herein are generally set forth as logical flow chart diagrams. As such, the depicted order and labeled steps are indicative of one example of the presented method. Other steps and methods may be conceived that are equivalent in function, logic, or effect to one or more steps, or portions thereof, of the illustrated method. Additionally, the format and symbols employed are provided to explain the logical steps of the method and are understood not to limit the scope of the method. Although various arrow types and line types may be employed in the flow chart diagrams, they are understood not to limit the scope of the corresponding method. Indeed, some arrows or other connectors may be used to indicate only the logical flow of the method. For instance, an arrow may indicate a waiting or monitoring period of unspecified duration between enumerated steps of the depicted method. Additionally, the order in which a particular method occurs may or may not strictly adhere to the order of the corresponding steps shown.

The present subject matter may be described in other specific forms. The described examples are to be considered in all respects only as illustrative and not restrictive.

The following clauses present further examples:
Clause 1. A method (200) of mitigating wrinkles during a manufacture of a super-plastically formed part, the method (200) comprising: arranging (202) a plurality of flat sheets (104) into a part assembly (106), the plurality of flat sheets (104) comprising a first outer sheet (108) and a second outer sheet (110); applying (204) a friction-modifying layer (120) to the first outer sheet (108) of the part assembly (106), wherein: the first outer sheet (108) comprises a first portion (116) having a first percentage of coverage and a second portion (118) having a second percentage of coverage; the friction-modifying layer (120) is applied at a first thickness (122) in the first portion (116) and a second thickness (124) in the second portion (118); and the first thickness (122) and the second thickness (124) are different thicknesses; placing (206) the part assembly (106) on a lower die (134) of a die system (130) such that the first outer sheet (108) is facing the lower die (134); and moving an upper die (132) of the die system (130) in a forming direction (136) toward the lower die (134) to stretch and compress the part assembly (106) between the upper die (132) and the lower die (134) and to super-plastically form the part assembly (106) into a formed part (102).
Clause 2. The method (200) of Clause 1, further comprising simulating a super-plastic formation (150) of a simulated part assembly (152) into a simulated formed part (154) to predict at least one wrinkle-prone location (114) within the simulated formed part (154).
Clause 3. The method (200) of Clause 2, wherein: the first portion (116) of the first outer sheet (108) corresponds with the at least one wrinkle-prone location (114) within the simulated formed part (154); the second portion (118) of the first outer sheet (108) corresponds with locations other than the at least one wrinkle-prone location (114) within the simulated formed part (154); and the step of applying the friction-modifying layer (120) to the first outer sheet (108) comprises applying the friction-modifying layer (120) to the first portion (116) at the first thickness (122) to mitigate wrinkles at the at least one wrinkle-prone location (114) while super plastically forming the part assembly (106) into the formed part (102).
Clause 4. The method (200) of any preceding Clause, wherein the step of applying the friction-modifying layer (120) to the first outer sheet (108) comprises applying the friction-modifying layer (120) to the first outer sheet (108) using a mask comprising at least one aperture corresponding with the first portion (116).
Clause 5. The method (200) of Clause 4, wherein a location of the at least one aperture of the mask, a shape of the at least one aperture, and a size of the at least one aperture are predetermined based on a simulation of a super-plastic formation of a simulated formed part (154).
Clause 6. The method (200) of any preceding Clause, further comprising: forming a corner cutout (140) at each corner (142) of the part assembly (106) to define a plurality of flanges (144), wherein each one of the plurality of flanges (144) extends between adjacent ones of the corner cutouts (140); and the step of moving the upper die (132) of the die system (130) in the forming direction comprises trapping each one of the plurality of flanges (144) between die-blocks (138), coupled to the upper die (132), and the lower die (134), as the upper die (132) of the die system (130) is moved in the forming direction (136) toward the lower die (134).
Clause 7. The method (200) of any preceding Clause, further comprising, prior to applying the friction-modifying layer (120), increasing a surface irregularity (158) in an irregular portion (160) of the first outer sheet (108) of the part assembly (106).
Clause 8. The method (200) of any preceding Clause, wherein the friction-modifying layer (120) is configured to precisely control a state of stress within the part assembly (106) when super-plastically forming the part assembly (106) into the formed part (102).
Clause 9. The method (200) of any preceding Clause, wherein: the first outer sheet (108) further comprises a third portion (126) having a third percentage of coverage; the friction-modifying layer (120) is applied at a third thickness (128) in the third portion (126); and the third thickness (128) is different than the first thickness (122) and the second thickness (124).
Clause 10. The method (200) of any preceding Clause, wherein the first thickness (122) is less than the second thickness (124).
Clause 11. The method (200) of any preceding Clause, wherein the plurality of flat sheets (104) further comprises at least one inner sheet (112) disposed between the first outer sheet (108) and the second outer sheet (110).
Clause 12. A method (300) of mitigating wrinkles during a manufacture of a super-plastically formed part, the method (300) comprising: subjecting (302) a part assembly (106) to a super-plastic forming process (100); and controlling (304) a state of stress within the part assembly (106) during the super-plastic forming process (100) by non-uniformly applying a friction-modifying layer (120) to an outer sheet (108) of the part assembly (106) prior to the super-plastic forming process (100), such that a thickness of the friction-modifying layer (120) at least one wrinkle-prone location (114) of the outer sheet (108) is different than a thickness of the friction-modifying layer (120) at other locations of the outer sheet (108).
Clause 13. The method (300) of Clause 12, wherein the thickness of the friction-modifying layer (120) at the at least one wrinkle-prone location (114) is less than the thickness of the friction-modifying layer (120) at other locations of the outer sheet (108).
Clause 14. The method (300) of Clause 12 or Clause 13, further comprising simulating a super-plastic formation (150) of a simulated part assembly (152) into a simulated formed part (154) to predict the at least one wrinkle-prone location (114) within the simulated formed part (154).
Clause 15. A formed part (102) produced by a process (100) comprising: arranging a plurality of flat sheets (104) into a part assembly (106), the plurality of flat sheets (104) comprising a first outer sheet (108) and a second outer sheet (110); applying a friction-modifying layer (120) to the first outer sheet (108) of the part assembly (106), wherein: the first outer sheet (108) comprises a first portion (116) having a first percentage of coverage and a second portion (118) having a second percentage of coverage; the friction-modifying layer (120) is applied at a first thickness (122) in the first portion (116) and a second thickness (124) in the second portion (118); and the first thickness (122) and the second thickness (124) are different thicknesses; placing the part assembly (106) on a lower die (134) of a die system (130) such that the first outer sheet (108) is facing the lower die (134); and moving an upper die (132) of the die system (130) in a forming direction (136) toward the lower die (134) to stretch and compress the part assembly (106) between the upper die (132) and the lower die (134) and to super-plastically form the part assembly (106) into the formed part (102).
Clause 16. The formed part (102) of Clause 15, wherein the part assembly (106) further comprises at least one inner sheet (112) disposed between the first outer sheet (108) and the second outer sheet (110).
Clause 17. The formed part (102) of Clause 16, wherein the at least one inner sheet (112) is formed into a network of cells between the first outer sheet (108) and the second outer sheet (110) when the part assembly (106) is super-plastically formed into the formed part (102).
Clause 18. The formed part (102) of Clause 15 or Clause 16, wherein at least one of the plurality of flat sheets (104) comprises at least one of a size, a shape, or a thickness that is different from the size, the shape, or the thickness of others of the plurality of flat sheets (104).
Clause 19. The formed part (102) of any of Clause 15 - 18, further comprising: forming a corner cutout (140) at each corner (142) of the part assembly (106) to define a plurality of flanges (144), wherein each one of the plurality of flanges (144) extends between adjacent ones of the corner cutouts (140); and the step of moving the upper die (132) of the die system (130) in the forming direction comprises trapping each one of the plurality of flanges (144) between die-blocks (138), coupled to the upper die (132), and the lower die (134), as the upper die (132) of the die system (130) is moved in the forming direction (136) toward the lower die (134).
Clause 20. The formed part (102) of any of Clause 15 - 19, wherein each one of the plurality of flat sheets (104) comprises a titanium material.
Clause 21. An aircraft comprising the formed part of any of Clauses 15 - 20.

## Claims

1. A method (200) of mitigating wrinkles during a manufacture of a super-plastically formed part, the method (200) comprising:
arranging (202) a plurality of flat sheets (104) into a part assembly (106), the plurality of flat sheets (104) comprising a first outer sheet (108) and a second outer sheet (110);
applying (204) a friction-modifying layer (120) to the first outer sheet (108) of the part assembly (106), wherein:
the first outer sheet (108) comprises a first portion (116) having a first percentage of coverage and a second portion (118) having a second percentage of coverage;
the friction-modifying layer (120) is applied at a first thickness (122) in the first portion (116) and a second thickness (124) in the second portion (118); and
the first thickness (122) and the second thickness (124) are different thicknesses;
placing (206) the part assembly (106) on a lower die (134) of a die system (130) such that the first outer sheet (108) is facing the lower die (134); and
moving an upper die (132) of the die system (130) in a forming direction (136) toward the lower die (134) to stretch and compress the part assembly (106) between the upper die (132) and the lower die (134) and to super-plastically form the part assembly (106) into a formed part (102).

2. The method (200) of claim 1, further comprising simulating a super-plastic formation (150) of a simulated part assembly (152) into a simulated formed part (154) to predict at least one wrinkle-prone location (114) within the simulated formed part (154).

3. The method (200) of claim 2, wherein:
the first portion (116) of the first outer sheet (108) corresponds with the at least one wrinkle-prone location (114) within the simulated formed part (154);
the second portion (118) of the first outer sheet (108) corresponds with locations other than the at least one wrinkle-prone location (114) within the simulated formed part (154); and
the step of applying the friction-modifying layer (120) to the first outer sheet (108) comprises applying the friction-modifying layer (120) to the first portion (116) at the first thickness (122) to mitigate wrinkles at at least one wrinkle-prone location (114) of the part assembly (106) while super plastically forming the part assembly (106) into the formed part (102).

4. The method (200) of any preceding claim, wherein the step of applying the friction-modifying layer (120) to the first outer sheet (108) comprises applying the friction-modifying layer (120) to the first outer sheet (108) using a mask comprising at least one aperture corresponding with the first portion (116), and optionally,
wherein a location of the at least one aperture of the mask, a shape of the at least one aperture, and a size of the at least one aperture are predetermined based on a simulation of a super-plastic formation of a simulated formed part (154).

5. The method (200) of any preceding claim, further comprising:
forming a corner cutout (140) at each corner (142) of the part assembly (106) to define a plurality of flanges (144), wherein each one of the plurality of flanges (144) extends between adjacent ones of the corner cutouts (140); and
the step of moving the upper die (132) of the die system (130) in the forming direction comprises trapping each one of the plurality of flanges (144) between die-blocks (138), coupled to the upper die (132), and the lower die (134), as the upper die (132) of the die system (130) is moved in the forming direction (136) toward the lower die (134).

6. The method (200) of any preceding claim, further comprising, prior to applying the friction-modifying layer (120), increasing a surface irregularity (158) in an irregular portion (160) of the first outer sheet (108) of the part assembly (106).

7. The method (200) of any preceding claim, wherein the friction-modifying layer (120) is configured to control a state of stress within the part assembly (106) when super-plastically forming the part assembly (106) into the formed part (102).

8. The method (200) of any preceding claim, wherein:
the first outer sheet (108) further comprises a third portion (126) having a third percentage of coverage;
the friction-modifying layer (120) is applied at a third thickness (128) in the third portion (126); and
the third thickness (128) is different than the first thickness (122) and the second thickness (124).

9. The method (200) of any preceding claim, wherein the first thickness (122) is less than the second thickness (124).

10. The method (200) of any preceding claim, wherein the plurality of flat sheets (104) further comprises at least one inner sheet (112) disposed between the first outer sheet (108) and the second outer sheet (110).

11. A super-plastically formed part (102) comprising:
a first outer sheet (108) and a second outer sheet (110); and
a friction-modifying layer (120) applied to the first outer sheet (108), wherein:
the first outer sheet (108) comprises a first portion (116) having a first percentage of coverage and a second portion (118) having a second percentage of coverage;
the friction-modifying layer (120) is located at a first thickness (122) in the first portion (116) and a second thickness (124) in the second portion (118); and
the first thickness (122) and the second thickness (124) are different thicknesses.

12. The super-plastically formed part (102) of claim 11, further comprising at least one inner sheet (112) disposed between the first outer sheet (108) and the second outer sheet (110), and optionally,
wherein the at least one inner sheet (112) forms a network of cells between the first outer sheet (108) and the second outer sheet (110).

13. The super-plastically formed part (102) of claim 11 or claim 12, wherein the first outer sheet (108)comprises at least one of a size, a shape, or a thickness that is different from the size, the shape, or the thickness of the second outer sheet (110).

14. The super-plastically formed part (102) of any of claims 11 - 13, wherein the first outer sheet (108) and the second outer sheet (110) comprise a titanium material.

15. An aircraft comprising the super-plastically formed part (102) of any of claims 11 - 14.
